Europäisches Patentamt

European Patent Office

Office européen des brevets

(11) Publication number: **0 054 408**

**B1**

(12) **EUROPEAN PATENT SPECIFICATION**

(45) Date of publication of patent specification: **03.07.85**

(21) Application number: **81305817.9**

(22) Date of filing: **09.12.81**

(51) Int. Cl.⁴: **H 03 K 19/013, H 03 K 19/088**

(54) Logic circuit.

(30) Priority: **11.12.80 JP 174852/80**

(43) Date of publication of application:
**23.06.82 Bulletin 82/25**

(45) Publication of the grant of the patent:
**03.07.85 Bulletin 85/27**

(84) Designated Contracting States:
**DE FR GB NL**

(56) References cited:
**US-A-3 217 181**

**Patent Abstracts of Japan Vol. 2, No. 116, 27 September 1978 page 6631E78**

(73) Proprietor: **FUJITSU LIMITED**
**1015, Kamikodanaka Nakahara-ku**
**Kawasaki-shi Kanagawa 211 (JP)**

(72) Inventor: **Tanizawa, Tetsu**
**440-1, Eda-cho Midori-Ku**
**Yokohama-shi Kanagawa 227 (JP)**

(74) Representative: **Abbott, Leonard Charles et al**
**GILL JENNINGS & EVERY 53-64 Chancery Lane**
**London WC2A 1HN (GB)**

## Description

The present invention relates to a logic circuit in which the rise time of the output signal is improved without significant penalty in power consumption.

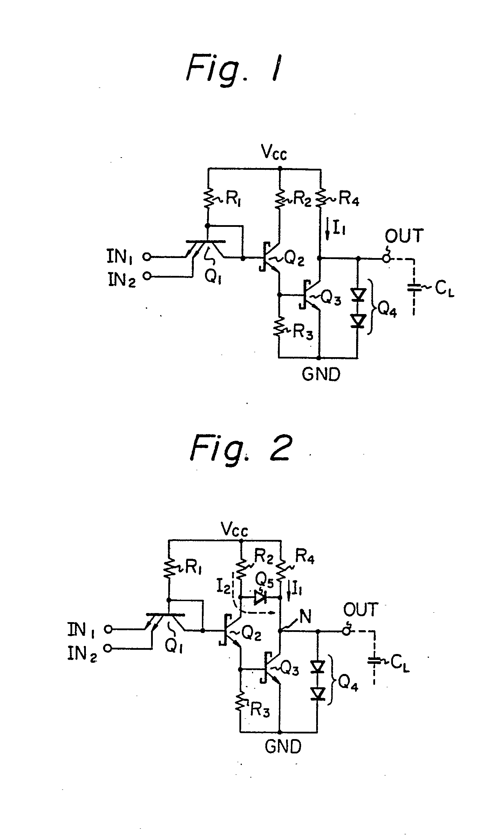

Before explaining the embodiments of the present invention, a conventional TTL (transistor-transistor logic) NAND circuit will first be explained with reference to Fig. 1. In Fig. 1, a multiemitter npn transistor $Q_1$ has a base connected through a resistor $R_1$ to a power supply line Vcc, a collector connected to the base of the transistor $Q_1$, and two emitters adapted to receive two input signals $IN_1$ and $IN_2$. The transistor $Q_1$ and the resistor $R_1$ constitute an AND circuit in which a logical product of the input signals $IN_1$ and $IN_2$ is obtained at the collector of the transistor $Q_1$. The collector of the transistor $Q_1$ is connected to the base of an npn transistor $Q_2$ which has a collector connected through a resistor $R_2$ to the power supply line Vcc and an emitter connected through a resistor $R_3$ to a ground line GND. The emitter of the transistor $Q_2$ is connected to the base of a transistor $Q_3$ which has a collector connected through a pull-up resistor $R_4$ to the power supply line Vcc and an emitter connected to the ground line GND. Clamping diodes $Q_4$ are connected in series between the collector and the emitter of the transistor $Q_3$. The clamping diodes $Q_4$ may be replaced by a resistor. The transistor $Q_2$ receives at its base a collector voltage from the transistor $Q_1$ and shifts the voltage to provide the shifted voltage to the base of the transistor $Q_3$. The transistor $Q_3$ inverts and amplifies the voltage received at its base to provide an output voltage at its collector connected to an output terminal. The resistor $R_3$ connected between the base of the transistor $Q_3$ and the ground line GND acts as a pull-down circuit for drawing charges at the base of the transistor $Q_3$ when the transistor $Q_3$ has been turned off. The resistor $R_3$ may be replaced by another pull-down circuit, for example, an active pull-down circuit. It should be noted that the transistors $Q_2$ and $Q_3$ are Schottky barrier transistors for preventing their excessive saturation.

In "Patents Abstracts of Japan", Vol. 2, No. 116 of 27th September 1978, page 6631 E 78 (JP—A—53—82253) there is disclosed a circuit employing Schottky barrier transistors which is similar to the above-described circuit employing components $Q_2$, $Q_3$, $R_2$, $R_3$, $R_4$ and $Q_4$.

The operation of the circuit of Figure 1 is well known in the art. Briefly explaining, when both of the input signals are at a high reference potential level (hereinafter referred to as an "H level"), the transistor $Q_1$ is in a cut-off state so that a current is supplied from the power supply line Vcc through the resistor $R_1$ to the base of the transistor $Q_2$ to turn it on. Because the transistor $Q_2$ is an emitter follower, the transistor $Q_3$ is then turned on so that the output voltage of the terminal OUT becomes a low reference potential level (hereinafter referred to as an "L level").

When at least one of the input signals $IN_1$ and $IN_2$ is at the L level, the current flowing through the resistor $R_1$ flows through the base and the emitter of the transistor $Q_1$ so that no base current is supplied to the base of the transistor $Q_2$. Thus, the transistors $Q_2$ and $Q_3$ are turned off. At this state, the pull-up resistor $R_4$ pulls the potential at the output terminal to the power supply voltage Vcc. The clamping diodes $Q_4$ determine the uppermost level of the H level.

The disadvantages of the conventional circuit of Figure 1 will now be described. During the transition from the ON state to the OFF state of the transistor $Q_3$, the charging of a capacitance $C_L$ of a wiring line or an input of a next stage transistor (not shown) connected to the output terminal OUT should be effected, when the potential at the output terminal OUT rises from the L level to the H level. Therefore, the rising speed of the potential at the output terminal OUT is determined by the capacity to charge the capacitance $C_L$. The capacitance $C_L$ may have various values depending on the circuits connected to the output terminal. The rising speed of the potential at the output terminal OUT should ideally be unaffected by the capacitance $C_L$.

One means considered to increase the capacity for charging the capacitance $C_L$, is to reduce the time constant derived from the pull-up resistor $R_4$ and the capacitance $C_L$ by decreasing the value of the resistor $R_4$. However, if the value of the resistor $R_4$ is decreased, the current $I_1$ which flows through the resistor $R_4$ will be increased. As current ordinarily flows through the resistor, the increased current $I_1$ causes an increase in the power consumption.

As another means to increase the capacity for charging the capacitance $C_L$, an active circuit, for example, a Darlington circuit may be connected between the collectors of the transistors $Q_2$ and $Q_3$. However, such an active circuit makes it impossible to operate the logic circuit at a low voltage of, for example, 2V, such a low voltage being used in recent LSI's (large scale integrated circuits).

Therefore, an object of the present invention is to provide a logic circuit in which the rate of rise of the output signal is improved without increasing the power consumption significantly.

Another object of the present invention is to provide a logic circuit integrated in an LSI, in which the rate of rise of the output signal of the logic circuit is improved without increasing the operating voltage.

In order to achieve the above objects, there is provided, according to the present invention, a logic circuit comprising: a first transistor with a Schottky barrier clamping diode, having a base adapted to receive an output voltage of a prestage logic gate, a collector, and an emitter for providing a voltage shifted from the output voltage of the prestage gate; a first resistor connected between the collector of the first transistor and a power supply line; a second transistor having a base connected to the emitter of the first transistor, a collector connected to an output terminal, and an emitter connected to a ground line; and a pull-up resistor connected between the collector of the second transistor and the power supply line, for pulling up the potential at the collector of the second transistor; whereby current flows from the power supply line to the output terminal along a path through the pull-up resistor; characterized by an additional diode having the anode connected to the collector of the first transistor and the cathode connected to the collector of the second transistor, whereby an additional current path is provided for temporarily allowing current flow from the power supply line through the first resistor and the diode to the output terminal during a transition from an ON state to an OFF state of the second transistor.

U.S.—A—3217181 discloses a circuit including a first transistor whose collector and emitter are connected through respective resistors to separate power supply lines, the emitter being also connected to the base of a second transistor; the second transistor has a grounded emitter and a collector connected to an output terminal and through a third resistor to a power supply; a diode is connected between the collectors of the first and second transistors. However, in this prior disclosure, the first transistor is not a Schottky barrier transistor. When the input changes from a high level (in which the first transistor is in heavy saturation and the second is only slightly saturated) to a low level, the change of the first transistor from on to off is slower than that of the second transistor, due to stored minority carriers in the base region of the first transistor; consequently during the change, the diode is turned off for a period during which it cannot provide an auxiliary path for pulling up the output voltage.

In order that the invention may be better understood, preferred embodiments of the invention will now be described with reference to the accompanying drawings, in which:

Figure 1 is a circuit diagram illustrating a conventional logic circuit;

Figure 2 is a circuit diagram illustrating a logic circuit according to an embodiment of the present invention;

Figure 3 is a graph illustrating the relation between the output voltage and the pull-up current in the circuit of Figure 2; and

Figure 4 is a circuit diagram illustrating a logic circuit according to another embodiment of the present invention.

Figure 2 is a circuit diagram illustrating a logic circuit according to an embodiment of the present invention. The difference between the circuit of Figure 1 and the circuit of Figure 2 is that, in Figure 2, a diode $Q_5$ is provided between the collectors of the transistors $Q_2$ and $Q_3$. The anode of the diode $Q_5$ is connected to the collector of transistor $Q_2$. The cathode of the diode $Q_5$ is connected to the collector of the transistor $Q_3$. The other portions are the same as the portions of the circuit of Fig. 1 and are designated by the same reference characters. Therefore, the constitution of the circuit of Fig. 2 is not described here.

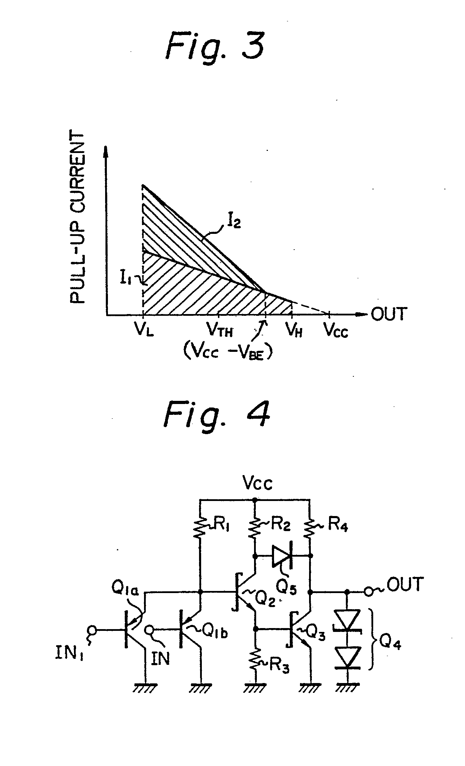

The operation of the circuit of Fig. 2 will be described with reference to Fig. 3. By providing the diode $Q_5$ in the polarity illustrated in Fig. 2, an additional current $I_2$ flows from the power supply line Vcc through the resistor $R_2$ and the diode $Q_5$ to the output terminal OUT, during the transition from the ON state to the OFF state of the transistor $Q_3$. Thus, because the pull-up current flowing through a node N connected to the collector of the transistor $Q_3$ and the output terminal OUT is $I_1+I_2$ greater than the pull-up current $I_1$ in Fig. 1 as illustrated in Fig. 3, the rise time of the output signal from the L level to the H level is shortened in comparison with the rise time in the circuit of Fig. 1.

Further, because the diode $Q_5$ is not always turned on, the current $I_2$ flows only temporarily. More precisely, the diode $Q_5$ is so designed as to satisfy the expression:

$$Vcc-V_{BE\ Q_5}<V_H$$

where Vcc represents the voltage of the power supply line Vcc, $V_{BE\ Q_5}$ represents the forward voltage of the diode $V_{BE}$, and $V_H$ represents the H level potential at the output terminal OUT determined by the diodes $Q_4$. When the diode $Q_5$ satisfies the above expression, the additional current $I_2$ flows only when the output voltage rises from the L level potential $V_L$ to $(Vcc-V_{BE\ Q_5})$. After the output potential at the output terminal OUT exceeds the value $Vcc-V_{BE}$, only the pull-up circuit $I_1$ flowing through the resistor $R_4$ flows through the clamping diodes $Q_4$. As a result, the rise time $t_{PLH}$, which is the transient time required for the transition from the L level to the H level of the output signal, is decreased in comparison with the conventional circuit of Fig. 1, while the power consumption is substantially the same in both circuits of Figs. 1 and 2. Because the rise time $t_{PLH}$ is decreased, the dependency of the rise time $t_{PLH}$ to the capacitance $C_L$, i.e., $\Delta t_{PLH}/\Delta C_L$, in the circuit of Fig. 2, is also decreased in comparison with the circuit of Fig. 1.

During the fall time of the transition from the H level to the L level, the additional current $I_2$ does not flow. This is because, when both of the input signals $IN_1$ and $IN_2$ are changed to the H level, the transistor $Q_1$ is turned off so that the base potential of the transistor $Q_2$ is increased to cause the transistor $Q_2$ to be turned on. Accordingly, the potential at the anode of the diode $Q_5$ is lowered to turn off the diode $Q_5$. The emitter current of the transistor $Q_2$ is supplied to the base of the transistor $Q_3$ to turn on the transistor $Q_3$. Thus the potential at the output terminal OUT falls to the L level. Because the diode $Q_5$ is in the cut-off state, the current flowing through the transistor $Q_3$ is only the current $I_1$ flowing through the pull-up resistor $R_4$ and the current supplied from the output terminal OUT. As a result, the falling speed of the output signal is not decreased in comparison with the conventional circuit of Fig. 1. Further, it is possible to design the values of the resistors $R_2$ and $R_4$ to be smaller and larger, respectively, in comparison with those in the circuit of Fig. 1, while the power consumptions in both circuits are designed to be the same. By decreasing the value of the resistor $R_2$, the base current of the transistor $Q_3$ is increased. Also, by increasing the value of the resistor $R_4$, the load of the transistor $Q_3$ is decreased. As a result of the increased base current and the decreased load, the fall characteristic of the output signal is also improved.

Although both of the transistors $Q_2$ and $Q_3$ are Schottky barrier transistors in the circuit of Fig. 2, the Schottky barrier clamping diode can be eliminated in the transistor $Q_3$. When the transistor $Q_3$ does not have a Schottky barrier clamping diode, the saturation voltage of the transistor $Q_3$ is

$$V_{BEQ_3}+V_{CESATQ_2}-V_{BEQ_5},$$

where $V_{BEQ_3}$ represents the base-emitter voltage of the transistor $Q_3$, $V_{CESATQ_2}$ represents the saturation voltage between the collector and the emitter of the transistor $Q_2$, and $V_{BEQ_5}$ represents the forward voltage of the diode $Q_5$. Since $V_{BEQ_3}$ is nearly equal to $V_{BEQ_5}$, the saturation voltage of the transistor $Q_3$ is nearly equal to $V_{CESATQ_2}$. This value $V_{CESATQ_2}$ is substantially equal to $V_{CESATQ_3}$, which is the saturation voltage of the transistor $Q_3$ when the transistor $Q_3$ has the Schottky barrier clamping diode. Accordingly, even when the transistor $Q_3$ does not have the Schottky barrier clamping diode, the transistor $Q_3$ is also prevented from being excessively saturated; and the effect of the present invention, that is, the rapid fall of the output signal without increasing the power consumption by conducting the current $I_2$ through the diode $Q_5$ only when the output voltage rises from the L level to $Vcc-V_{BEQ_5}$, can be obtained.

If the transistor $Q_2$ does not have a Schottky barrier clamping diode, the additional current $I_2$ will not be effectively obtained, because, in this case, the transistor $Q_2$ is excessively saturated when its base potential is at the H level, and therefore, the rise of its collector potential is delayed even after its base potential has fallen and the transistor $Q_3$ has begun to turn off so that the diode $Q_5$ will not be turned on. The potential at the collector of the transistor $Q_2$, i.e., the anode of the diode $Q_5$, rises to the H level only after minority carriers on the base of the transistor $Q_2$ have been discharged. Therefore, in order to obtain the effects of the present invention, at least the transistor $Q_2$ should have a Schottky barrier clamping diode.

Fig. 4 is a circuit diagram illustrating a logic circuit, according to another embodiment of the present invention. The difference between the circuit of Fig. 2 and Fig. 4 is that, in Fig. 4, two input-stage pnp transistors $Q_{1a}$ and $Q_{1b}$ are employed in place of the npn multiemitter transistor $Q_1$ in Fig. 2. The emitters of the transistors $Q_{1a}$ and $Q_{1b}$ are commonly connected to the base of the transistor $Q_2$. The collectors of the transistors $Q_{1a}$ and $Q_{1b}$ are grounded. The bases of the transistors $Q_{1a}$ and $Q_{1b}$ are adapted to receive the input signals $IN_1$ and $IN_2$, respectively. The rest of the circuit configuration is the same as that of Fig. 2. The circuit of Fig. 4 is a NAND circuit. The effect of rapid fall of the output signal without increasing the power consumption can also be obtained by the circuit of Fig. 4, as will easily be understood by those skilled in the art.

From the foregoing description, it will be understood that, according to the present invention, a logic circuit can be obtained in which the rising speed of the output signal is improved without increasing the power consumption and without increasing the operating voltage.

The present invention is not restricted to the illustrated embodiments, but various changes and modifications, for example, various logics are possible without departing from the spirit of the invention.

**Claims**

1. A logic circuit comprising:
a first transistor ($Q_2$) with a Schottky barrier clamping diode, having a base adapted to receive an output voltage of a pre-stage logic gate, a collector, and an emitter for providing a voltage shifted from the output voltage of the pre-stage gate;
a first resistor ($R_2$) connected between the collector of the first transistor and a power supply line (Vcc);
a second transistor ($Q_3$) having a base connected to the emitter of the first transistor, a collector connected to an output terminal, and an emitter connected to a ground line; and
a pull-up resistor ($R_4$) connected between the collector of the second transistor and the power supply line, for pulling up the potential at the collector of the second transistor ($Q_3$), whereby current flows from the power supply line to the output terminal along a path through the pull-up resistor ($R_4$); characterized by an additional diode ($Q_5$) having the anode connected to the collector of the first transistor ($Q_2$) and the cathode connected to the collector of the second transistor ($Q_3$), whereby an additional current path is provided for temporarily allowing current flow from the power supply line through the first resistor ($R_2$) and the diode ($Q_5$) to the output terminal during a transition from an ON state to an OFF state of the second transistor ($Q_3$).

2. A logic circuit as set forth in claim 1, wherein the second transistor ($Q_3$) comprises a Schottky barrier clamping diode.

3. A logic circuit as set forth in claim 1 or 2, wherein the additional diode ($Q_5$) has a forward voltage $V_{BE}$ satisfying the expression:

$$Vcc-V_{BE}<V_H,$$

where Vcc represents the voltage of the power supply line; and $V_H$ represents the high reference potential at the output terminal.

4. A logic circuit as set forth in claim 3, comprising a clamping circuit connected between the output terminal and the ground line, for determining the value $V_H$.

**Patentansprüche**

1. Logikschaltung mit:
einem ersten Transistor ($Q_2$) mit einer Schottky-Barrieren-Klammerdiode, die eine Basis hat, die zum Empfang einer Ausgangsspannung eines Logikgliedes einer Vorstufe ausgebildet ist, einem Kollektor und einem Emitter, der eine Spannung liefert, welche gegenüber der Ausgangsspannung des Verknüpfungsgliedes der Vorstufe verschoben ist;
einem ersten Widerstand ($R_2$), der zwischen den Kollektor des ersten Transistors und einer Stromversorgungsleitung (Vcc) geschaltet ist;
einem zweiten Transistor ($Q_3$), dessen Basis mit dem Emitter des ersten Transistors verbunden ist, dessen Kollektor mit einem Ausgangsanschluß verbunden ist und dessen Emitter mit der Erdleitung verbunden ist; und
einem Pull-up-Widerstand ($R_4$), der zwischen dem Kollektor des zweiten Transistors und der Stromversorgungsleitung angeschlossen ist und dazu dient, das Potential bei dem Kollektor des zweiten Transistors hochzuziehen, wodurch Strom von der Stromversorgungsleitung zu dem Ausgangsanschluss längs einem Weg durch den Pull-up-Widerstand ($R_4$) fließt;
gekennzeichnet durch eine zusätzliche Diode ($Q_5$), deren Anode mit dem Kollektor des ersten Transistors ($Q_2$) und deren Kathode mit dem Kollektor des zweiten Transistors ($Q_3$) verbunden ist, wodurch ein zusätzlicher Stromweg geschaffen wird, um während eines Übergangs von dem Ein-Zustand des zweiten Transistors ($Q_3$) zu dem Aus-Zustand temporär einen Strom von der Stromversorgungsleitung durch den ersten Widerstand ($R_2$) und die Diode ($Q_5$) zu dem Ausgangsanschluß fließen zu lassen.

2. Logikschaltung nach Anspruch 1, bei welcher der zweite Transistor ($Q_3$) eine Schottky-Barrieren-Klammerdiode umfaßt.

3. Logikschaltung nach Anspruch 1 oder 2, bei welcher die zusätzliche Diode ($Q_5$) eine Vorwärts-spannung ($V_{BE}$) aufweist, welche die folgende Gleichung erfüllt:

$$Vcc - V_{BE} < V_H,$$

wobei Vcc die Spannung der Stromversorgungsleitung und $V_H$ das hohe Referenzpotential an dem Ausgangsanschluß bezeichnet.

4. Logikschaltung nach Anspruch 3, mit einer Klammerschaltung, die zwischen dem Ausgangsanschluß und der Erdleitung geschaltet ist, um den Wert $V_H$ zu bestimmen.

**Revendications**

1. Circuit logique comprenant:
un premier transistor ($Q_2$) avec une diode de verrouillage à barrière de Schottky, possédant une base destinée à recevoir une tension de sortie d'une porte logique prévue en avant, un collecteur et un émetteur pour fournir une tension décalée par rapport à la tension de sortie de ladite porte;
une première résistance ($R_2$) connectée entre le collecteur du premier transistor et une ligne d'alimentation (Vcc);
un second transistor ($Q_3$) possédant une base reliée à l'émetteur du premier transistor, un collecteur relié à une borne de sortie et un émetteur relié à une ligne de masse; et
une résistance élévatrice ($R_4$) connectée entre le collecteur du second transistor et la ligne d'alimentation, pour faire monter le potentiel au collecteur du second transistor ($Q_3$), avec circula-tion d'un courant depuis la ligne d'alimentation à la borne de sortie suivant un parcours traversant la résistance élévatrice ($R_4$); caractérisé par une diode additionnelle ($Q_5$) reliée par l'anode au collecteur du premier transistor ($Q_2$) et par la cathode au collecteur du second transistor ($Q_3$), ce qui crée un parcours de courant additionnel pour permettre la circulation temporaire de courant depuis la ligne d'alimentation à travers la première résistance ($R_2$) et la diode ($Q_5$) à la borne de sortie pendant la transition du second tran-sistor ($Q_3$) de l'état conducteur à l'état bloqué.

2. Circuit logique selon la revendication 1, où le second transistor ($Q_3$) comprend une diode de verrouillage à barrière de Schottky.

3. Circuit logique selon la revendication 1 ou 2, où la diode additionnelle ($Q_5$) présente une ten-sion directe $V_{BE}$ qui satisfait l'expression:

$$Vcc - V_{BE} < V_H,$$

où Vcc représente la tension de la ligne d'alimentation et $V_H$ représente le potentiel de référence élevé sur la borne de sortie.

4. Circuit logique selon la revendication 3, comprenant un circuit de verrouillage relié entre la borne de sortie et la ligne de masse pour déterminer la valeur $V_H$.

# Fig. 1

# Fig. 2

# Fig. 3

# Fig. 4